# EUROPEAN PATENT APPLICATION

(11) **EP 4 753 150 A1**
(43) Date of publication of application: **03.06.2026**
(21) Application number: 25216666.5
(22) Date of filing: 18.11.2025
(51) Int. Cl.: H03L 7/087, H03L 7/089, H03L 7/18

(54) **PHASE FREQUENCY DETECTOR WITH SATURATED OUTPUT**

(30) Priority: 27.11.2024 US 202463725848 P; 14.11.2025 US 202519389362
(71) Applicant: STMicroelectronics International N.V., 1228 Plan-les-Ouates, Geneva (CH)
(72) Inventor: GUPTA, Prashutosh, 201310 Greater Noida (IN); RASTOGI, Krishna, 226003 Lucknow (IN)
(74) Representative: Casalonga

(57) **Abstract**

A phase frequency detector circuit, a method for generating a first output signal and a second output signal based on a reference signal and a feedback signal, and a phase-locked loop are provided. The phase frequency detector circuit includes a plurality of reference signals, a plurality of feedback signals, a first output signal, and a second output signal. The plurality of reference signals, including a primary reference signal having a reference triggering edge. The plurality of feedback signals, including a primary feedback signal having a feedback triggering edge. The first output signal and the second output signal indicating a phase difference between the primary reference signal and the primary feedback signal. The first output signal remains asserted after the primary feedback signal arrives, when the phase difference exceeds a max phase difference indicated by a difference between the primary reference signal and the reference signal.

## Description

### CROSS-REFERENCE TO RELATED APPLICATIONS

This application claims the benefit of U.S. Provisional Patent Application No. 63/725,848, filed November 27, 2024, the entire contents of which are hereby incorporated by reference in their entirety.

### TECHNOLOGICAL FIELD

Embodiments of the present disclosure relate generally to phase frequency detectors, and more particularly, to phase frequency detectors utilized in phase-locked loops.

### BACKGROUND

A phase-frequency detector (PFD) in a phase-locked loop (PLL) is essential for comparing the phase and frequency of two input signals, typically a reference signal and a feedback signal from the phase-locked loop's output. A phase frequency detector generates an output based on the phase and/or frequency difference between the two input signals. The output of the phase frequency detector is then used to control a voltage-controlled oscillator (VCO), adjusting the frequency of the output signal of the voltage-controlled oscillator to align with the input reference signal. Some applications require rapid convergence of the phase-locked loop output signal with the reference signal.

Applicant has identified many technical challenges and difficulties associated with accurate output of a phase frequency detector. Through applied effort, ingenuity, and innovation, Applicant has solved problems related to the operation of phase frequency detectors by developing solutions embodied in the present disclosure, which are described in detail below.

### BRIEF SUMMARY

Various embodiments are directed to an example phase frequency detector circuit, a method for generating a first output signal and a second output signal based on a reference signal and a feedback signal, and a phase-locked loop comprising a phase frequency detector. An example phase frequency detector circuit is provided. The example phase frequency detector circuit includes a plurality of reference signals, a plurality of feedback signals, a first output signal, and a second output signal. The plurality of reference signals, including a primary reference signal comprising a reference triggering edge. The plurality of feedback signals, including a primary feedback signal comprising a feedback triggering edge. The first output signal and the second output signal indicating a phase difference between the primary reference signal and the primary feedback signal. Wherein in an instance in which the phase difference exceeds a max phase difference indicated by a difference between the primary reference signal and the reference signal, the first output signal remains in an asserted state after an arrival of the primary feedback signal.

In some embodiments, the first output signal is transitioned to an asserted state based on the reference triggering edge of the primary reference signal arriving before the feedback triggering edge of the primary feedback signal.

In some embodiments, the plurality of reference signals further comprise a second reference signal wherein the primary reference signal is generated by delaying the second reference signal by a reference delay, the second reference signal comprising a second reference triggering edge.

In some embodiments, the max phase difference is defined based on a difference between the reference triggering edge and the second reference triggering edge.

In some embodiments, the phase frequency detector circuit further comprises a secondary up output signal based on the first output signal and the second reference signal, wherein the secondary up output signal is transitioned to an asserted state in an instance in which the first output signal is at an asserted state and the second reference triggering edge of the second reference signal is received.

In some embodiments, in an instance in which the first output signal and the secondary up output signal are at an asserted state and the feedback triggering edge of the primary feedback signal is received, the secondary up output signal transitions to a de-asserted state and the first output signal remains in an asserted state.

In some embodiments, in an instance in which the first output signal is in an asserted state, the secondary up output signal is in a de-asserted state, and the feedback triggering edge of the primary feedback signal is received, the first output signal transitions to a de-asserted state.

In some embodiments, the plurality of feedback signals further comprise a second feedback signal wherein the primary feedback signal is generated by delaying the second feedback signal by a feedback delay, the second feedback signal comprising a second feedback triggering edge.

In some embodiments, the phase frequency detector further comprises a secondary down output signal based on the second output signal and the second feedback signal, wherein the secondary down output signal is transitioned to an asserted state in an instance in which the second output signal is in an asserted state and the second feedback triggering edge of the second feedback signal is received.

In some embodiments, in an instance in which the second output signal and the secondary down output signal are in an asserted state and the reference triggering edge of the primary reference signal is received, the secondary down output signal transitions to a de-asserted state and the second output signal remains in an asserted state.

In some embodiments, in an instance in which the second output signal is in an asserted state, the secondary down output signal is in a de-asserted state, and the reference triggering edge of the primary reference signal is received, the second output signal transitions to a de-asserted state.

In some embodiments, the phase frequency detector circuit further comprises a first stage configured to generate the first output signal based on the primary reference signal, and the second output signal based on the primary feedback signal. The phase frequency detector circuit further comprises a second stage configured to generate a secondary up output signal based on the first output signal and a second reference signal, and a secondary down output signal based on the second output signal and a second feedback signal.

In some embodiments, the first stage comprises a first flip-flop and a second flip-flop. The first flip-flop configured to receive the primary reference signal, a first reset signal, and a source voltage, and generate the first output signal. The second flip-flop configured to receive the primary feedback signal, a second reset signal, and the source voltage, and generate the second output signal.

In some embodiments, the first flip-flop and the second flip-flop are active high flip-flops.

In some embodiments, the first reset signal and the second reset signal are based on the secondary up output signal and the secondary down output signal, respectively.

In some embodiments, the second stage further comprises a third flip-flop and a fourth flip-flop. The third flip-flop configured to receive the second reference signal, a third reset signal, and the first output signal, and generate the secondary up output signal. The fourth flip-flop configured to receive a secondary feedback signal, the third reset signal, and the second output signal, and generate the secondary down output signal.

In some embodiments, the third flip-flop and the fourth flip-flop are active low flip-flops.

In some embodiments, the phase frequency detector circuit further comprises a logical NAND gate configured to receive the first output signal and the second output signal and generate the third reset signal based on a logical NAND operation of the first output signal and the second output signal.

A method for generating a first output signal and a second output signal at a phase frequency detector circuit based on a reference signal and a feedback signal is further provided. In some embodiments, the method comprises: generating a primary reference signal, wherein the primary reference signal is generated by delaying the reference signal by a reference delay; generating a primary feedback signal, wherein the primary feedback signal is generated by delaying the feedback signal by a feedback delay; and generating the first output signal and the second output signal, indicating a phase difference between the reference signal and the feedback signal, wherein in an instance in which the phase difference exceeds a max phase difference indicated by a difference between the primary reference signal and the reference signal, the first output signal remains at an asserted state after an arrival of the primary feedback signal.

A phase-locked loop configured to generate an output signal based on a reference clock is further provided. In some embodiments, the phase-locked loop, comprises a voltage-controlled oscillator, a low-pass filter, a charge pump, and a phase frequency detector. The voltage-controlled oscillator configured to generate the output signal based on an oscillating voltage signal. The low-pass filter electrically connected to the voltage-controlled oscillator and configured to generate the oscillating voltage signal based on a charge pump output signal. The charge pump circuit electrically connected to the low-pass filter and configured to generate the charge pump output signal based on a first output signal and a second output signal. The phase frequency detector circuit, comprising a plurality of reference signals, a plurality of feedback signals, the first output signal, and the second output signal. The plurality of reference signals based on the reference clock, including a primary reference signal comprising a reference triggering edge. The plurality of feedback signals based on the oscillating voltage signal, including a primary feedback signal comprising a feedback triggering edge. The first output signal and the second output signal, indicating a phase difference between the primary reference signal and the primary feedback signal. Wherein in an instance in which the phase difference exceeds a max phase difference indicated by a difference between the primary reference signal and the reference signal, the first output signal remains at an asserted state after an arrival of the primary feedback signal.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates an example block diagram of a phase-locked loop in accordance with an example embodiment of the present disclosure.
FIG. 2 illustrates an example state diagram of a typical 3-state phase frequency detector.
FIG. 3 illustrates an example circuit diagram of a typical 3-state phase frequency detector.
FIG. 4 depicts an example state diagram of phase frequency detector in accordance with an example embodiment of the present disclosure.
FIG. 5 depicts an example transfer function of a phase frequency detector configured in accordance with an example embodiment of the present disclosure.
FIG. 6 depicts an example circuit diagram on an example phase frequency detector designed in accordance with an example embodiment of the present disclosure.
FIG. 7 depicts an example timing diagram illustrating a secondary up output delay in accordance with an example embodiment of the present disclosure.
FIG. 8 depicts an example timing diagram illustrating an affect of the feedback delay in accordance with an example embodiment of the present disclosure.
FIG. 9 depicts an example timing diagram illustrating an affect of a delay between the second reference signal and the primary reference signal in accordance with an example embodiment of the present disclosure.
FIG. 10 depicts a graph illustrating an improved retrace duration for a phase frequency detector in accordance with an example embodiment of the present disclosure.
FIG. 11 depicts a graph illustrating an improved lock time of a phase-locked loop comprising a phase frequency detector in accordance with an example embodiment of the present disclosure.
FIG. 12 depicts an example circuit diagram of a phase frequency detector in accordance with an example embodiment of the present disclosure.
FIG. 13 depicts an example circuit diagram of a phase frequency detector in accordance with an example embodiment of the present disclosure.
FIG. 14 depicts an example circuit of a phase frequency detector in accordance with an example embodiment of the present disclosure.
FIG. 15 depicts a flow diagram illustrating an example process for generating a first output signal and a second output signal at a phase frequency detector in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Many digital signals are described in relation to the present embodiments. Digital signals may occupy one of two states. Throughout the description, the two states may be described as a logical high state or a logical low state. A digital signal is at a logical high state when an electrical characteristic of the digital signal is above a logical threshold. For example, an instance in which a voltage of the digital signal exceeds a logical threshold voltage. A digital signal is at a logical low state when an electrical characteristic of the digital signal is below a logical threshold. For example, an instance in which a voltage of the digital signal is below a logical threshold voltage. The logical states of a digital signal may also be indicated by 0 (e.g., logical low state) and 1 (e.g., logical high state) as used interchangeably throughout.

When referencing a digital signal, the term "asserted/de-asserted" refers to the logical state of the digital signal when the digital signal is active. An active high digital signal is in an asserted state in an instance in which the digital signal is in a logical high state, and in a de-asserted state in an instance in which the digital signal is in a logical low state. An active low digital signal is an asserted state in an instance in which the digital signal is in a logical low state, and in a de-asserted state in an instance in which the digital signal is in a logical high state.

Digital signals may transition from one logical state to another. A transition from a logical low state to a logical high state may be referred to as a rising edge of the digital signal. A transition from a logical high state to a logical low state may be referred to as a falling edge of the digital signal. A triggering edge refers to the transition of the digital signal that causes an action in an electronic device. A triggering edge may refer to either a rising edge or a falling edge. For example, in some embodiments, a state machine may transition states based on a rising edge, while in other embodiments a state machine may transition states based on a falling edge. In such an instance, the edge of the digital signal causing the transition may be referred to as the triggering edge.

Various example embodiments of the present disclosure address technical problems associated with generating accurate output signals from a phase frequency detector based on input reference and feedback signals. As understood by those of skill in the field to which the present disclosure pertains, there are numerous example systems which may benefit from a phase frequency detector configured to generate accurate output signals.

For example, a phase-locked loop is an electronic circuit that synchronizes an output signal's phase and frequency to a reference signal. In general, a phase-locked loop determines an error between the reference signal and the output signal and a feedback signal of the phase-locked loop and utilizes the difference to adjust the voltage supplied to a voltage-controlled oscillator. Phase-locked loop's may be utilized in many applications, for example, applications involving frequency synthesis, such as radio transmitters, receivers, and signal generators; clock generation, such as clock generation blocks in CPUs, GPUs, and networking equipment; communication systems, such as synchronizing data signals in wired and wireless communications; motor control and robotics applications; telecommunications applications; and so on.

In one example, phase-locked loops may be utilized in the generation and control of chirp signals in a radar system. Chirp signals are frequency-modulated signals that sweep across a range of frequencies over a set time. A chirp signal may be essential in a radar system to determine accurate distances and speeds of target objects. A reference signal may be utilized to define the parameters of the chirp signal, for example, the start and stop frequencies, and the rate of the chirp signal. A phase-locked loop stabilizes and controls the frequency sweep of the chirp signal by synchronizing the voltage-controlled oscillator of the phase-locked loop with the reference signal. In such an embodiment, the retrace time (e.g., flyback time)-the time between the highest frequency of a chirp and the lowest frequency of the next sequential chirp-may be quite small. Thus, a phase-locked loop may be required to move quickly from a high frequency to a low frequency (or vice versa) in a short amount of time.

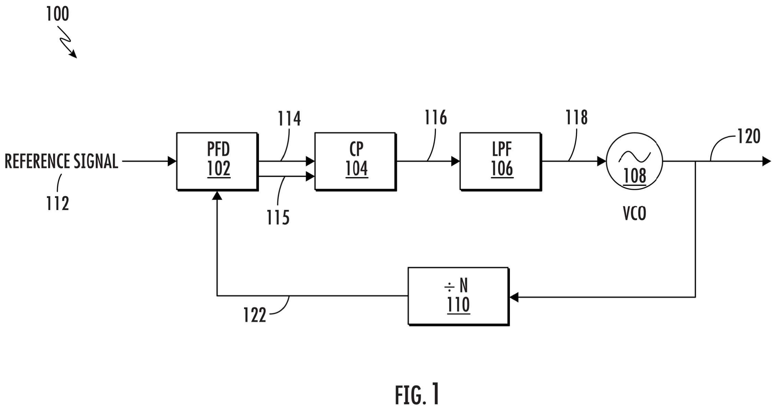

Referring now to FIG. 1, an example, phase-locked loop 100 is provided. As depicted in FIG. 1, the example phase-locked loop 100 includes a phase frequency detector 102 configured to receive a reference signal 112 and a feedback signal 122. The phase frequency detector 102 is configured to determine a frequency and/or phase difference between the reference signal 112 and the feedback signal 122 and generate an up output signal 114 and a down output signal 115 based on the frequency and/or phase difference.

As further depicted in FIG. 1, the phase frequency detector 102 is electrically connected to a charge pump 104. The charge pump 104 comprises any circuitry including hardware and/or software configured to convert the up output signal 114 and the down output signal 115 into a control voltage (e.g., charge pump output 116) compatible with the voltage-controlled oscillator 108. The charge pump 104 may boost the voltage, convert the voltage, or perform any other operation necessary to convert the up output signal 114 and the down output signal 115 into a control voltage. For example, in some embodiments, the up output signal 114 may control a transistor device electrically connected to a voltage source and configured to increase the voltage of the charge pump output 116 when the up output signal 114 is asserted. In some embodiments, the down output signal 115 may control a transistor device electrically connected to an electrical ground and configured to decrease the voltage of the charge pump output 116 when the down output signal 115 is asserted.

As further depicted in FIG. 1, the charge pump 104 is electrically connected to a loop filter 106. The loop filter 106 comprises any circuitry including hardware and/or software configured to receive and filter the voltage generated by the up output signal 114 and the down output signal 115 to generate a filtered output voltage (e.g., oscillator voltage 118). The loop filter 106 may remove high frequency noise or perform other similar signal filtering operations to generate the oscillator voltage 118.

As further depicted in FIG. 1, the loop filter 106 is electrically connected to a voltage-controlled oscillator 108. A voltage-controlled oscillator 108 comprises any circuitry including hardware and/or software configured to generate an output signal 120 with a frequency that is adjusted and/or controlled based on the voltage of the oscillator voltage 118. In some embodiments, the frequency of the output signal 120 may be directly proportional to the oscillator voltage 118. Thus, in some embodiments, in an instance in which the up output signal 114 is asserted, the voltage of the charge pump output 116 and the oscillator voltage 118 increases, increasing the frequency of the output signal 120. Conversely, in an instance in which the down output signal 115 is asserted, the voltage of the charge pump output 116 and the oscillator voltage 118 decreases, decreasing the frequency of the output signal 120.

As further depicted in FIG. 1, the output signal 120 of the voltage-controlled oscillator 108 is fed back to a frequency divider 110. A frequency divider 110 comprises any circuitry including hardware and/or software configured to receive the output signal 120 and generate a feedback signal 122 having a different frequency than the output signal 120. In some embodiments, the frequency divider 110 may cause the feedback signal 122 to oscillate at a lower frequency than the output signal 120.

As depicted in FIG. 1, when positioned in the feedback line of the phase-locked loop 100, the frequency divider 110 enables frequency synthesis, scaling, and stability in the output signal 120 of the phase-locked loop 100 based on the reference signal 112. For example, to generate an output signal 120 based on the reference signal 112, but scaled to a higher frequency, the frequency divider 110 may generate the feedback signal 122 at a reduced frequency of the output signal 120 (e.g., reduced by a factor of N). The reduced frequency feedback signal 122 is provided to the phase frequency detector 102 and compared with the reference signal 121. The comparison enables the phase-locked loop 100 to lock the output signal 120 to an integer multiple of the reference signal 121. By adjusting the divider ratio (N) of the frequency divider 110, the phase-locked loop 100 can effectively multiply the reference signal 112 to generate a stable output signal 120 at higher frequencies. For example, if the desired frequency of the output signal is 10 megahertz and the reference signal 112 oscillates at 1 megahertz, the divider ratio (N) may be set to 10, enabling the phase-locked loop 100 to lock the output signal 120 at 10 megahertz.

In some embodiments, the divide ratio may be dynamically updated to generate an output signal 120 of different frequencies. For example, in an instance in which a chirp radar signal is generated, the divide ratio may be continuously updated over a set time to generate a frequency-modulated output signal 120 that sweeps across a range of frequencies over the set time. In some instances, the divide ratio may change significantly, for example in a chirp retrace. The accuracy of the device (e.g., radar) may be dependent upon the duration required by the phase-locked loop 100 to re-lock after a change in the divide ratio.

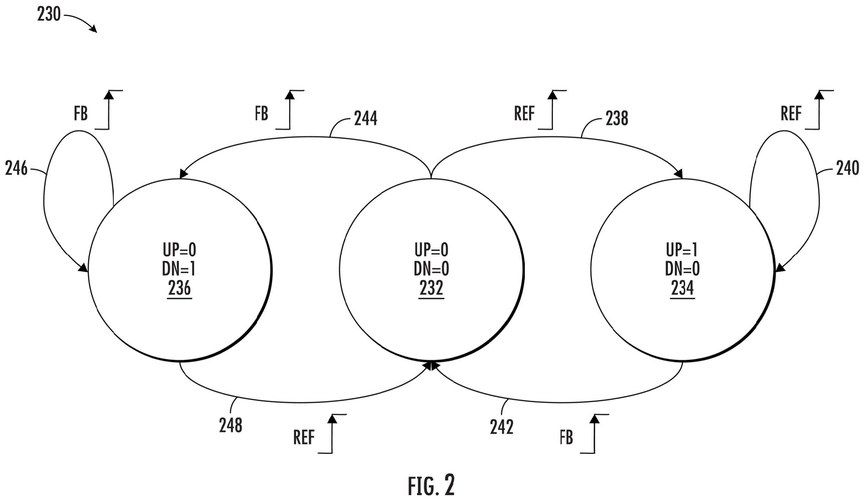

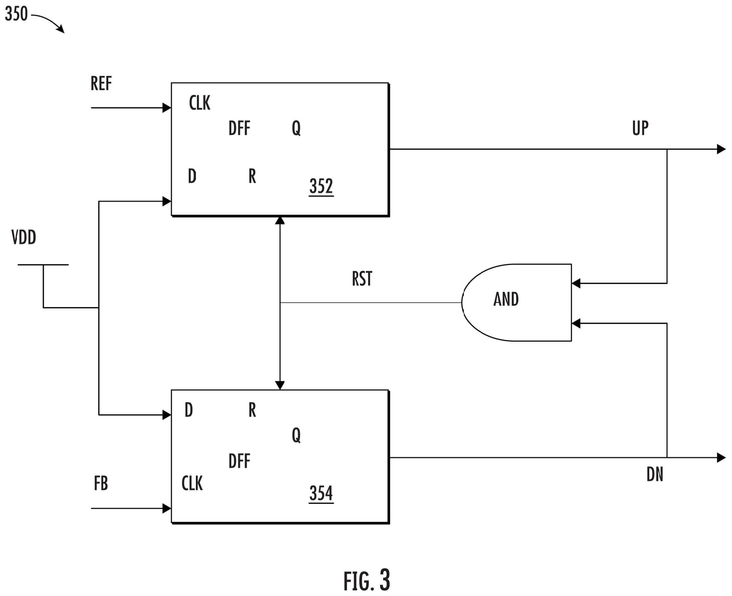

FIG. 2 depicts an example traditional state diagram 230 depicting the three stable states for a traditional phase frequency detector with corresponding example circuitry depicted in FIG. 3. As depicted in FIG. 3, the traditional phase frequency detector circuit 350 includes a first D-type flip-flop 352 and a second D-type flip-flop 354. A reference signal (REF) is connected to the clock of the first D-type flip-flop 352 while the feedback signal (FB) is connected to the clock of the second D-type flip-flop 354. The data input terminal (D) of the first D-type flip-flop 352 and the second D-type flip-flop 354 are both electrically connected to a voltage source (VDD). The first D-type flip-flop 352 generates the up output signal (UP) while the second D-type flip-flop 354 generates the down output signal (DN). The reset signal (RST) to both the first D-type flip-flop 352 and the second D-type flip-flop 354 are based on the logical and (AND) of the up output signal (UP) and down output signal (DN).

Returning to FIG. 2, the example traditional phase frequency detector circuit 350 operates in accordance with the example traditional state diagram 230. As depicted in FIG. 2, the example traditional state diagram 230 comprises three states and transition between the states is dependent on the timing of the triggering edge (e.g., rising edge) of the reference signal (e.g., REF in FIG. 3) and the feedback signal (e.g., FB in FIG. 3). The logic state of the up output signal (UP) and down output signal (DN) are indicated at each state.

At the first state 232, both the up output signal (UP) and down output signal (DN) are at a logic low state (e.g., 0). In an instance in which a triggering edge (e.g., rising edge as depicted in FIG. 2) of the reference signal (REF) arrives first, the traditional state diagram 230 follows transition 238 to the state 234. Conversely, in an instance in which a triggering edge (e.g., rising edge) of the feedback signal (FB) arrives first, the traditional state diagram 230 follows transition 244 to the state 236.

At state 234, the up output signal (UP) is at a logic high state (e.g., 1) and the down output signal (DN) is at a logic low state. Any triggering edge of the reference signal (REF) while in the state 234, indicated by transition 240, causes the traditional state diagram 230 to remain in state 234 where the up output signal (UP) is at a logic high state (e.g., 1) and the down output signal (DN) is at a logic low state. The arrival of a triggering edge of the feedback signal (FB) causes the traditional state diagram 230 to follow transition 242 back to state 232.

At state 236, the up output signal (UP) is at a logic low state and the down output signal (DN) is at a logic high state. Any triggering edge of the feedback signal (FB) while in the state 236, indicated by transition 246, causes the traditional state diagram 230 to remain in state 236 where the up output signal (UP) is at a logic low state and the down output signal (DN) is at a logic high state. The arrival of a triggering edge of the reference signal (REF) causes the traditional state diagram 230 to follow transition 248 back to state 232.

The traditional phase frequency detector circuit (phase frequency detector circuit 350 in FIG. 3) and corresponding state diagram (traditional state diagram 230 depicted in FIG. 2) suffer from a number of drawbacks. For example, cycle slipping and output flipping.

Cycle slipping most commonly occurs during start-up and/or when significant changes to the desired frequency of the output signal occur. In such instances, the frequency difference and/or the phase offset of the reference signal and the feedback signal may be significant. Significant differences in the frequency and/or phase offset of the reference signal and the feedback signal may cause the phase frequency detector to lose track of the phase alignment. During cycle slipping, the phase-locked loop cannot maintain a steady output signal. The output signal experiences repeated slipping and then abrupt correction when trying to synchronize with the reference signal. In some examples, designers have attempted to mitigate problems associated with cycle slipping by increasing the bandwidth of the phase-locked loop, however, increasing the bandwidth of the phase-locked loop causes increased phase noise in the output signal of the phase-locked loop.

Output flipping occurs near the edge of the linear range of the phase frequency detector. Output flipping occurs in an instance in which the phase frequency detector reverses the output signals. For example, output flipping may occur if the reset to the flip-flops comes during the sampling edge of either the reference signal or the feedback signal. In such an instance, the phase information related to the arriving signal is lost. Due to this, the phase frequency detector may flip the output direction in the next cycle.

Both cycle slipping and output flipping result in longer lock times of a phase-locked loop. Longer lock times may be especially problematic in applications with small retrace/flyback time requirements, for example, radar chirp applications. Longer lock times caused by cycle slipping and output flipping may adversely affect the operation of electronic devices utilizing the phase-locked loop.

The various example embodiments described herein utilize various techniques to improve the operation of a phase frequency detector. For example, various embodiments described herein provide phase frequency detector circuitry configured to operate in five stable states. The five stable states of the phase frequency detector circuitry saturate the phase frequency detector output in an instance in which the phase difference and/or frequency difference of input signals (e.g., reference signal and feedback signal) exceeds a maximum phase difference. The phase frequency detector architecture described herein comprises two stages, with each stage operating at different phases of the reference signal (e.g., primary reference signal, second reference signal) and the feedback signal (e.g., primary feedback signal, second feedback signal).

In general, in an instance in which the triggering edge of the primary reference signal leads the primary feedback signal, while the second reference signal (based on the primary reference signal) comes after, or in close vicinity, of the primary feedback signal than the behavior of the five state phase frequency detector is similar to the traditional three state phase frequency detector. However, in an instance in which the primary feedback signal arrives well after the second reference signal, the up output signal of the phase frequency detector is held in a logical high state. Similarly, in an instance in which the primary reference signal arrives well after the second feedback signal, the down output signal of the phase frequency detector is held in a logical high state. Thus, by increasing the number of stable states of the phase frequency detector, cycle slipping is avoided as the phase frequency detector outputs (e.g., up output signal, down output signal) saturate beyond a certain max phase difference between the primary reference signal and the primary feedback signal.

Saturating the output of the phase frequency detector beyond a certain max phase difference results in lower retrace times and faster lock acquisition. As a result of the herein described example embodiments and in some examples, the accuracy of a phase frequency detector may be greatly improved.

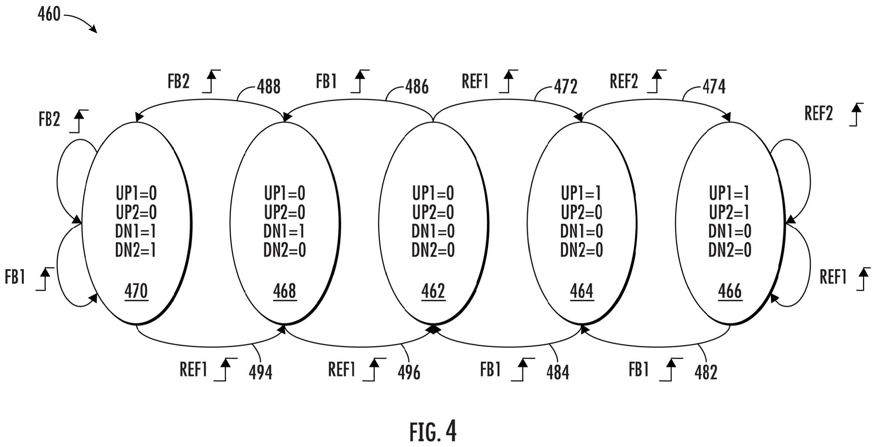

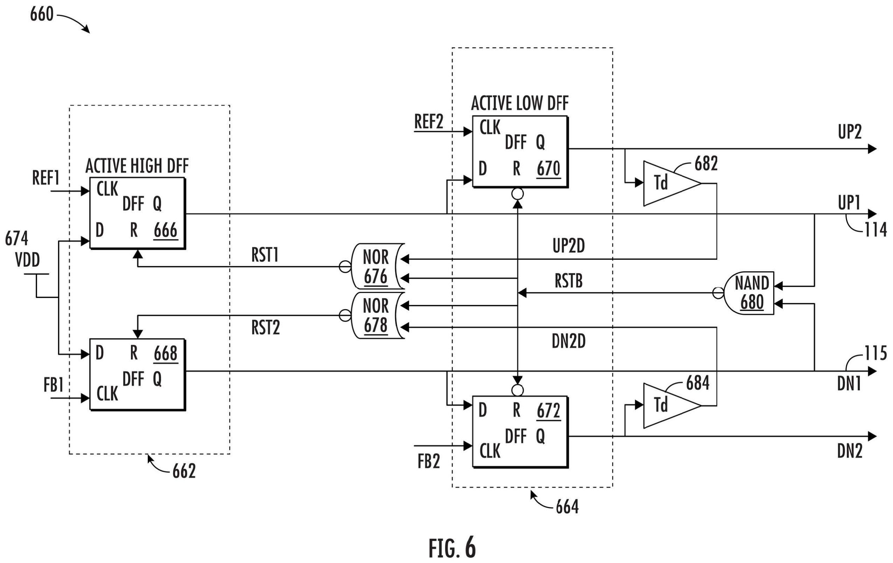

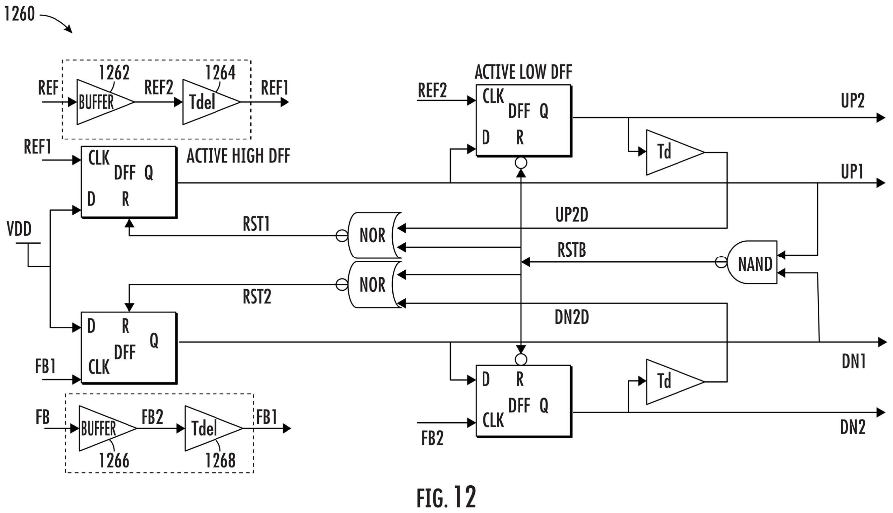

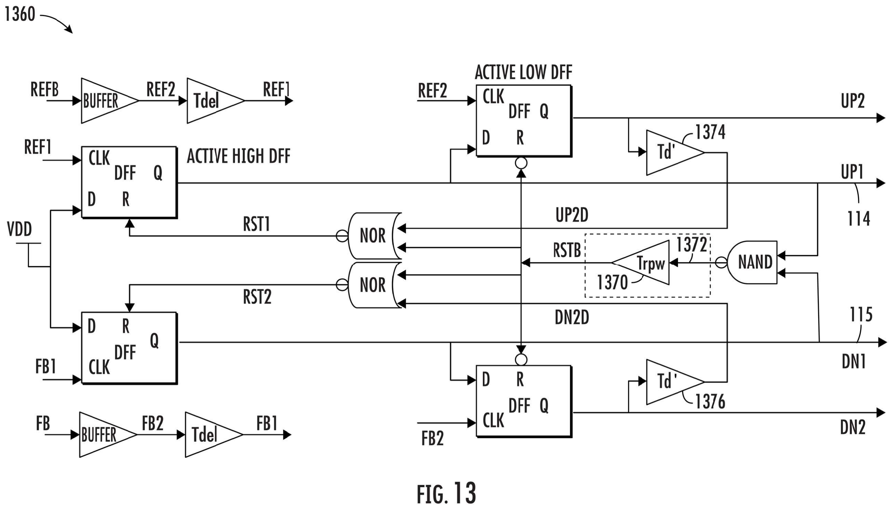

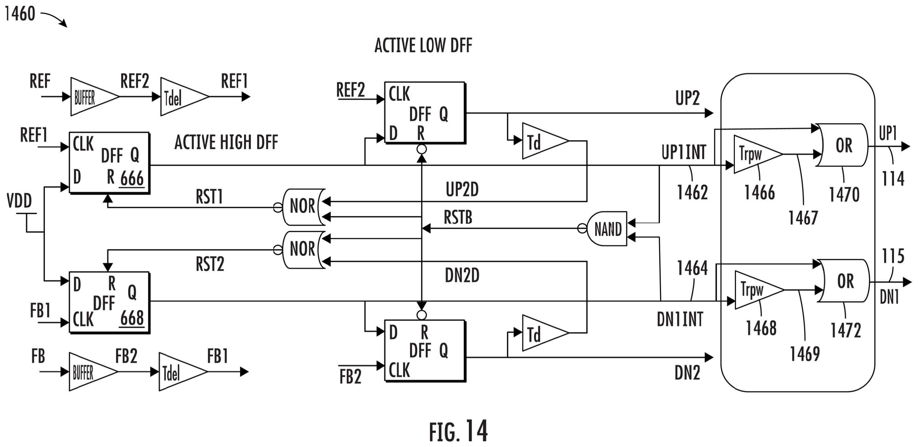

Referring now to FIG. 4, an example five-state state diagram 460 is depicted. The example five-state state diagram 460 illustrates the functionality of one or more phase frequency detector circuits (e.g., phase frequency detector circuit 660 described in relation to FIG. 6, phase frequency detector circuit 1260 described in relation to FIG. 12, phase frequency detector circuit 1360 described in relation to FIG. 13, phase frequency detector circuit 1460 described in relation to FIG. 14) described in relation to the present disclosure.

As depicted in FIG. 4, the five-state state diagram 460 comprises five states (e.g., state 462, state 464, state 466, state 468, state 470). The logic state of the first up output signal (UP1), second up output signal (UP2), first down output signal (DN1), and second down output signal (DN2) are indicated at each state. Although a first up output signal (UP1), second up output signal (UP2), first down output signal (DN1), and second down output signal (DN2) are generated, only two output signals are output by the phase frequency detector (e.g., first up output signal (UP1) and first down output signal (DN1)). As described herein, the first up output signal (UP1) corresponds to the first output signal of the phase frequency detector and first down output signal (DN1) corresponds to the second output signal of the phase frequency detector.

Transitions between the states of the five-state state diagram 460 are dependent on the arrival of a triggering edge of the primary reference signal (REF1), the second reference signal (REF2), the primary feedback signal (FB1), and the second feedback signal (FB2). As depicted in FIG. 4, the triggering edge is the rising edge of the reference signals and the feedback signals, however, in some embodiments, state transitions may occur based on the falling edge of the reference signals and the feedback signals.

As depicted in FIG. 4, a phase frequency detector circuit based on the five-state state diagram 460 utilizes a primary reference signal and a second reference signal. In some embodiments, both the primary reference signal and the second reference signal are generated based on the reference signal received at the phase frequency detector. For example, the primary reference signal and the second reference signal may oscillate at the same frequency as the reference signal, however, one or both of the primary reference signal and the second reference signal may be phase shifted with reference to the reference signal.

The second reference signal is phase shifted relative to the primary reference signal. For example, the second reference signal may be shifted such that the rising edge of the second reference signal is in close proximity but preceding the primary reference signal. In some embodiments, the reference signal may pass through a delay element comprising a delay shorter than half of the oscillation cycle of the reference signal. In such an embodiment, the reference signal corresponds to the second reference signal, while the delayed reference signal corresponds to the primary reference signal.

As further depicted in FIG. 4, a phase frequency detector circuit based on the five-state state diagram 460 utilizes a primary feedback signal and a second feedback signal. In some embodiments, both the primary feedback signal and the second feedback signal are generated based on the feedback signal received at the phase frequency detector. For example, the primary feedback signal and the second feedback signal may oscillate at the same frequency as the feedback signal, however, one or both of the primary feedback signal and the second feedback signal may be phase shifted with reference to the feedback signal.

The second feedback signal is phase shifted relative to the primary feedback signal. For example, the second feedback signal may be shifted such that the rising edge of the second feedback signal is in close proximity but preceding the primary feedback signal. In some embodiments, the feedback signal may pass through a delay element comprising a delay shorter than half of the oscillation cycle of the feedback signal. In such an embodiment, the feedback signal corresponds to the second feedback signal, while the delayed feedback signal corresponds to the primary feedback signal.

At state 462, the first up output signal (UP1), second up output signal (UP2), first down output signal (DN1), and second down output signal (DN2) are all at a logical low state. Transitions from the state 462 are based on the primary reference signal (REF1) and the primary feedback signal (FB1). In an instance in which a triggering edge (e.g., rising edge) of the primary reference signal arrives, the transition 472 occurs and the phase frequency detector circuit is transitioned to the state 464. In an instance in which a triggering edge (e.g., rising edge) of the primary feedback signal arrives, the transition 486 occurs and the circuit is transitioned to the state 468.

At state 464, the first up output signal (UP1) is at a logical high state, while the second up output signal (UP2), first down output signal (DN1), and second down output signal (DN2) are all at a logical low state. Transitions from the state 464 are based on the second reference signal

(REF2) and the primary feedback signal (FB1). In an instance in which a triggering edge (e.g., rising edge) of the second reference signal arrives, the transition 474 occurs and the circuit is transitioned to the state 466. In an instance in which a triggering edge (e.g., rising edge) of the primary feedback signal arrives, the transition 484 occurs and the circuit is transitioned to the state 462.

The arrival of the second reference signal before the primary feedback signal while in state 464 indicates that both the primary reference signal and the second reference signal arrive at the phase frequency detector circuit before the triggering edge of the primary feedback signal. Arrival of both the primary reference signal and the second reference signal before the triggering edge of the primary feedback signal is an indicator of a phase difference between the reference signal and the feedback signal greater than a max phase difference. The max phase difference may be defined as the time difference between the triggering edge of the primary reference signal and the triggering edge of the second reference signal. In some embodiments, the max phase difference may be defined by the clock cycle of the primary reference signal minus the reference delay plus the delay (ΔTfb) between the second reference signal (REF2) and the primary feedback signal (FB1), where the reference delay is the time by which the second reference signal is delayed to generate the primary reference signal.

At state 466, the first up output signal (UP1) and the second up output signal (UP2) are at a logical high state, while the first down output signal (DN1) and the second down output signal (DN2) are both at a logical low state. Transitions from the state 466 are based on the primary feedback signal (FB1). Any additional arrivals of the primary reference signal and the second reference signal at the phase frequency detector circuit keep the phase frequency detector circuit in state 466. In an instance in which a triggering edge (e.g., rising edge) of the primary feedback signal arrives at the phase frequency detector circuit, the transition 482 occurs and the circuit is transitioned back to state 464.

At state 468, the first down output signal (DN1) is at a logical high state, while the first up output signal (UP1), second up output signal (UP2), and second down output signal (DN2) are all at a logical low state. Transitions from the state 468 are based on the second feedback signal (FB2) and the primary reference signal (REF1). In an instance in which a triggering edge (e.g., rising edge) of the second feedback signal arrives, the transition 488 occurs and the phase frequency detector circuit is transitioned to the state 470. In an instance in which a triggering edge (e.g., rising edge) of the primary reference signal arrives, the transition 496 occurs and the circuit is transitioned to the state 462.

The arrival of the second feedback signal before the primary reference signal while in state 468 indicates that both the primary feedback signal and the second feedback signal arrive at the phase frequency detector circuit before the triggering edge of the primary reference signal. Arrival of both the primary feedback signal and the second feedback signal before the triggering edge of the primary reference signal is an indicator of a phase difference between the reference signal and the feedback signal greater than a max phase difference. The max phase difference may be defined as the time difference between the triggering edge of the primary feedback signal and the triggering edge of the second feedback signal. In some embodiments, the max phase difference may be defined by the clock cycle of the primary feedback signal minus the feedback delay plus the delay (ΔTfb) between the second reference signal (REF2) and the primary feedback signal (FB1), where the feedback delay is the time by which the second feedback signal is delayed to generate the primary feedback signal.

At state 470, the first down output signal (DN1) and the second down output signal (DN2) are at a logical high state, while the first up output signal (UP1) and the second up output signal (UP2) are both at a logical low state. Transitions from the state 470 are based on the primary reference signal (REF1). Any additional arrivals of the primary feedback signal and the second feedback signal at the phase frequency detector circuit keep the phase frequency detector circuit in state 470. In an instance in which a triggering edge (e.g., rising edge) of the primary reference signal arrives at the phase frequency detector circuit, the transition 494 occurs and the circuit is transitioned back to state 468.

By designing a phase frequency detector circuit according to the five-state state diagram 460 depicted in FIG. 4, outputs (e.g., first up output signal, first down output signal) of the phase frequency detector circuit are saturated in instances in which the phase difference between the reference signal and the feedback signal exceed a max phase difference. Thus, a phase-locked loop utilizing the phase frequency detector circuit described herein may mitigate cycle slipping and output flipping, exhibiting improvements in lock time, especially in instances in which one or more frequencies of the reference signal or feedback signal change rapidly and/or significantly.

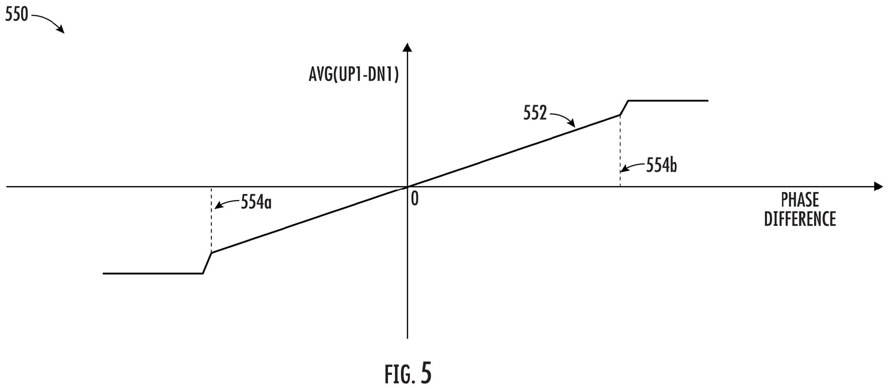

Referring now to FIG. 5, an example graph 550 depicting an example transfer function 552 for the outputs (e.g., up output signal, down output signal) of a phase frequency detector circuit in accordance with the present disclosure is depicted.

As depicted in FIG. 5, the example transfer function 552 depicts the average difference between the up output signal and the down output signal across a range of phase differences. The phase difference represents the difference in phase and/or frequency of a reference signal and a feedback signal received at a phase frequency detector circuit. A positive phase difference indicates a reference signal having a higher frequency or preceding the feedback signal. A negative phase difference indicated the feedback signal having a higher frequency or preceding the reference signal.

As depicted in FIG. 5, the transfer function 552 is linear between the feedback max phase difference 554a and the reference max phase difference 554b. The feedback max phase difference 554a is defined by the time or phase difference between the triggering edge (e.g., rising edge) of the primary feedback signal and the triggering edge of the second feedback signal. In some embodiments, the feedback max phase difference 554a may be defined by the clock cycle of the primary feedback signal minus a feedback delay plus the delay (ΔTfb) between the second reference signal (REF2) and the primary feedback signal (FB1). The reference max phase difference 554b is defined by the time or phase difference between the triggering edge (e.g., rising edge) of the primary reference signal and the triggering edge of the second reference signal. In some embodiments, the reference max phase difference 554b may be defined by the clock cycle of the primary reference signal minus a reference delay plus the delay (ΔTfb) between the second reference signal (REF2) and the primary feedback signal (FB1).

In an instance in which the phase difference between the feedback signal and the reference signal exceeds the feedback max phase difference 554a (e.g., the feedback signal frequency is greater than the reference signal frequency), the transfer function 552 saturates. Meaning, the down output signal is at a logical high level when the phase difference is anywhere beyond the feedback max phase difference 554a. Such an outcome corresponds with a phase frequency detector circuit in the state 470 of a five-state state diagram 460 as depicted in FIG. 4.

Similarly, in an instance in which the phase difference between the reference signal and the feedback signal exceeds the reference max phase difference 554b (e.g., the reference signal frequency is greater than the feedback signal frequency), the transfer function 552 saturates. Meaning, the up output signal is at a logical high level when the phase difference is anywhere beyond the reference max phase difference 554b. Such an outcome corresponds with a phase frequency detector circuit in the state 466 of a five-state state diagram 460 as depicted in FIG. 4.

Referring now to FIG. 6, an example phase frequency detector circuit 660 configured to operate in accordance with a five-state state diagram (e.g., five-state state diagram 460) is depicted. As depicted in FIG. 6, the phase frequency detector circuit 660 includes two stages, a first stage 662 configured to receive the primary reference signal (REF1) and the primary feedback signal (FB1) and generate the up output signal 114 (e.g., first output signal) and the down output signal 115 (e.g., second output signal). As further depicted in FIG. 6, the phase frequency detector circuit 660 includes a second stage 664 configured to receive the up output signal 114, the down output signal 115, the second reference signal (REF2), and the second feedback signal (FB2) to generate a second up output signal (UP2) and a second down output signal (DN2).

As described herein, the second reference signal oscillates at the same frequency as the primary reference signal but is shifted such that the rising edge of the second reference signal is proximate the rising edge of the primary reference signal and precedes the rising edge of the primary reference signal. For example, in some embodiments, the primary reference signal is generated by passing the second reference signal through a delay element.

As further described herein, the second feedback signal oscillates at the same frequency as the primary feedback signal but is shifted such that the rising edge of the second feedback signal is proximate the rising edge of the primary feedback signal and precedes the rising edge of the primary feedback signal. For example, in some embodiments, the primary feedback signal is generated by passing the second feedback signal through a delay element.

As depicted in FIG. 6, the first stage 662 includes a first flip-flop 666 and a second flip-flop 668. In some embodiments, the first flip-flop 666 and the second flip-flop 668 may be active high d-type flip-flops.

The first flip-flop 666 is configured to receive the primary reference signal (REF1) at a clock input (CLK) and a source voltage 674 at the data input (D). The first flip-flop 666 further receives a first reset signal (RST1) at a reset input (R). The first flip-flop 666 outputs the up output signal 114 at the output terminal (Q).

The second flip-flop 668 is configured to receive the primary feedback signal (FB1) at a clock input (CLK) and the source voltage 674 at the data input (D). The second flip-flop 668 further receives a second reset signal (RST2) at a reset input (R). The second flip-flop 668 outputs the down output signal 115 at the output terminal (Q).

As further depicted in FIG. 6, the second stage 664 includes a third flip-flop 670 and a fourth flip-flop 672. In some embodiments, the third flip-flop 670 and the fourth flip-flop 672 may be active low d-type flip-flops.

The third flip-flop 670 is configured to receive the second reference signal (REF2) at a clock input (CLK) and the up output signal 114 at the data input (D). The third flip-flop 670 further receives a third reset signal (RSTB) at a reset input (R). The third flip-flop 670 outputs the second up output signal (UP2) at the output terminal (Q).

The fourth flip-flop 672 is configured to receive the second feedback signal (FB2) at a clock input (CLK) and the down output signal 115 at the data input (D). The fourth flip-flop 672 further receives the third reset signal (RSTB) at a reset input (R). The fourth flip-flop 672 outputs the second down output signal (DN2) at the output terminal (Q).

As further depicted in FIG. 6, the second up output signal (UP2) is transmitted to a secondary up output delay 682, which is configured to generate a delayed second up output signal (UP2D). The delayed second up output signal is equivalent to the second up output signal (UP2) but delayed based on the delay of the secondary up output delay 682. Similarly, the second down output signal (DN2) is transmitted to a secondary down output delay 684, which is configured to generate a delayed second down output signal (DN2D). The delayed second down output signal is equivalent to the second down output signal (DN2) but delayed based on the delay of the secondary down output delay 684.

As further depicted in FIG. 6, the NAND gate 680 is configured to receive the up output signal 114 and the down output signal 115 and generate the third reset signal (RSTB) based on the logical NAND of the up output signal 114 and the down output signal 115.

As further depicted in FIG. 6, the NOR gate 676 is configured to receive the delayed second up output signal (UP2D) and the third reset signal (RSTB) and generate the first reset signal (RST1) based on the logical NOR of the delayed second up output signal (UP2D) and the third reset signal (RSTB). Similarly, the NOR gate 678 is configured to receive the delayed second down output signal (DN2D) and the third reset signal (RSTB) and generate the second reset signal (RST2) based on the logical NOR of the delayed second down output signal (DN2D) and the third reset signal (RSTB).

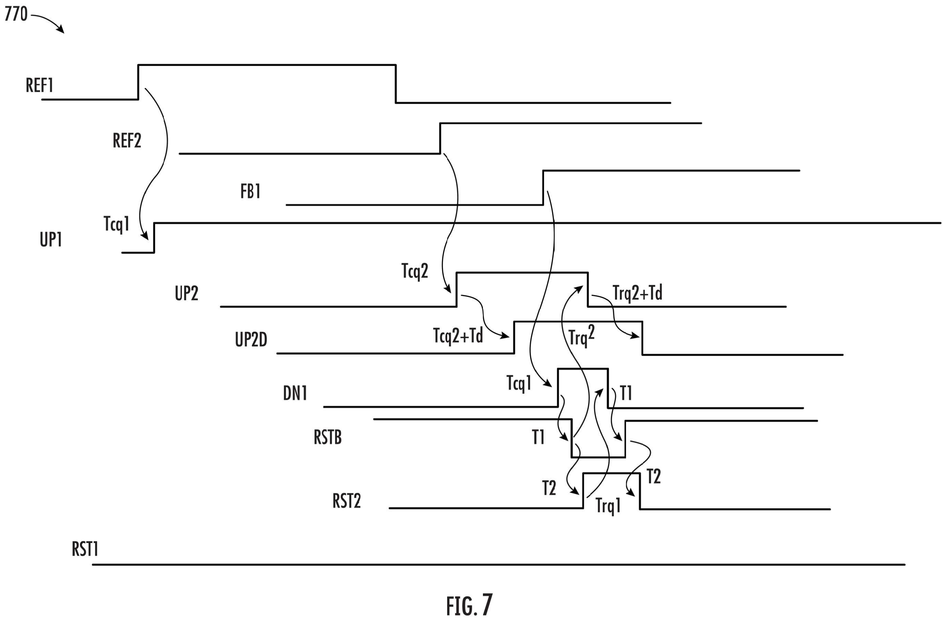

Referring now to FIG. 7, an example timing diagram 770. As depicted in FIG. 7, the delay of the secondary up output delay (Td) (e.g., secondary up output delay 682 as depicted in FIG. 6) is selected to ensure the up output signal 114 remains at a logical high state in an instance in which the second up output signal (UP2) is also in a logical high state and the triggering edge of the primary feedback signal (FB1) arrives. To ensure the up output signal 114 remains at a logical high state, the second up output signal (UP2D) must not go to a logical low state before the third reset signal (RSTB) goes to a logical high state. Thus, the secondary up output delay (Td) exceeds the R to Q delay of the second flip-flop 668 minus the R to Q delay of the fourth flip-flop 672 plus the delay of the NAND gate 680 plus the delay of the NOR gate 678. Since the R to Q delay of the second flip-flop 668 and the fourth flip-flop 672 are virtually equivalent, the delay of the secondary up output delay (Td) should exceed the delay of the NAND gate 680 plus the delay of the NOR gate 678. The secondary down output delay may be similarly determined.

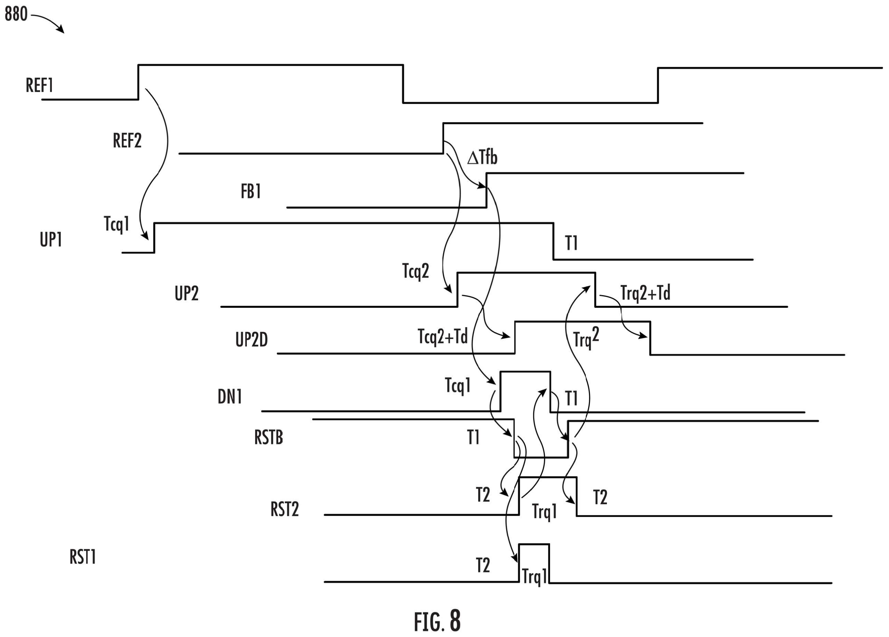

Referring now to FIG. 8, an example timing diagram 880 is provided. As depicted in FIG. 8, the delay between the second reference signal (REF2) and the primary feedback signal (FB1) is depicted as ΔTfb. As depicted in FIG. 8, the delay ΔTfb determines the range of frequencies for which the phase frequency detector circuit behaves linearly, meaning the output signals (e.g., up output signal, down output signal) may be reset. As shown by FIG. 8, if ΔTfb is greater than the secondary output delay (e.g., secondary up output delay, secondary down output delay) minus the NAND gate delay, the phase frequency detector circuit no longer acts linearly but is saturated. Thus, if the secondary output delay is high, the linear range of the phase frequency detector circuit is also extended.

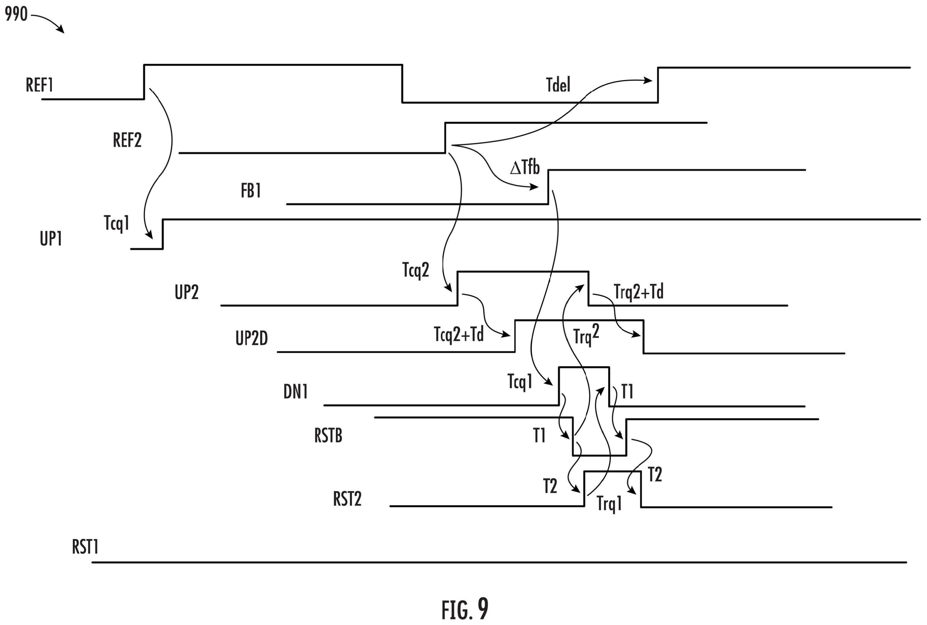

Referring now to FIG. 9, an example timing diagram 990 is provided. The timing diagram 990 depicts the delay (Tdel) between the rising edge of the second reference signal (REF2) and the primary reference signal (REF1). In general, the delay (Tdel) between the rising edge of the second reference signal (REF2) and the primary reference signal (REF1) should ensure that that the second up output signal (UP2) is at a logical high state before the next triggering edge of the primary reference signal (REF1) arrives. Thus, the delay (Tdel) between the rising edge of the second reference signal (REF2) and the primary reference signal (REF1) should be greater than the secondary up output delay (Td) plus the clock to Q delay of the third flip-flop 670. In some embodiments, the up output signal can still go to a logic low state when the second up output signal is in a logic high state and the triggering edge of the primary feedback signal arrives. In such an instance, the phase frequency detector circuit may ensure that ate the next triggering edge of the primary reference signal, the up output signal may go to a logic high state again. Such a case can be ensure in an instance in which the delay (Tdel) between the rising edge of the second reference signal (REF2) and the primary reference signal (REF1) is greater than the secondary up output delay (Td) plus the clock to Q of the third flip-flop 670 plus the delay of the NOR gate 676 plus the reset to Q of the first flip-flop 666. Such a buffer between the rising edge of the second reference signal (REF2) and the primary reference signal (REF1) may further prevent cycle slipping when locking the reference signal and the feedback signal.

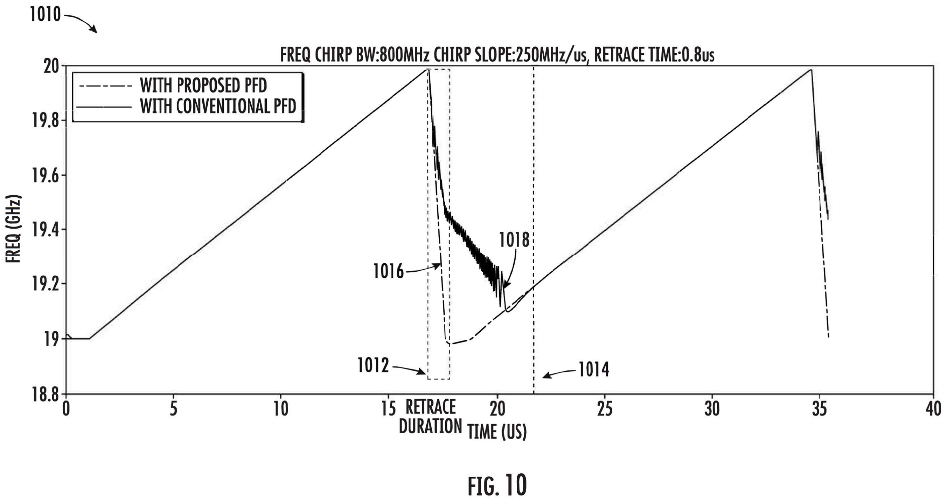

Referring now to FIG. 10, an example graph 1010 comparing the five-state phase frequency detector circuit frequency 1016 and the traditional three-state phase frequency detector circuit frequency 1018 during a frequency retrace operation, is depicted.

As depicted in FIG. 10, during a frequency retrace operation, the frequency output of a phase-locked loop moves from an end frequency in the frequency chirp (e.g., 20 gigahertz) back down to the start frequency in the frequency chirps (e.g., 19 gigahertz). In some applications, the time for the phase-locked loop to retrace (e.g., lock at the start frequency) may affect the performance of the overall system. For example, if a phase-locked loop takes too long to retrace, the accuracy of the system may degrade.

As depicted in FIG. 10, the graph 1010 depicts a frequency 1018 showing a frequency response for a phase frequency detector circuit utilizing a traditional three-state approach (e.g., phase frequency detector circuit 350 as depicted in FIG. 3). As shown, the traditional three-state approach results in cycle slipping and thus an elongated settling time (e.g., settling time 1014). Such a settling time may not be acceptable for a chirp application requiring a shorter settling time.

As further depicted in FIG. 10, the graph 1010 depicts a frequency 1016 showing a frequency response for a phase frequency detector circuitry utilizing a five-state phase frequency detector circuit (e.g., phase frequency detector circuit 660 described in relation to FIG. 6, phase frequency detector circuit 1260 described in relation to FIG. 12, phase frequency detector circuit 1360 described in relation to FIG. 13, phase frequency detector circuit 1460 described in relation to FIG. 14). The retrace duration 1012 of the frequency 1016 is significantly shorter (e.g., 1 - 2 microseconds). Thus, the phase frequency detector circuit may be utilized in applications requiring a shorter settling time (e.g., retrace time), such as chirp applications.

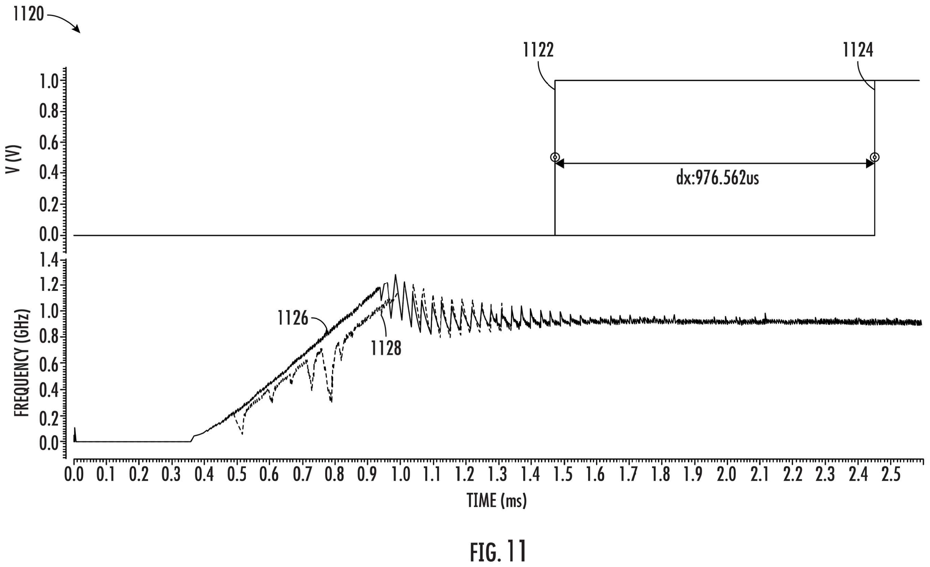

Referring now to FIG. 11, another example graph 1120 comparing the five-state phase frequency detector circuit frequency 1126 and the traditional three-state phase frequency detector circuit frequency 1128 during phase-locked loop start-up is depicted.

As depicted in the lower portion of graph 1120, the example phase-locked loops are locking to an initial output frequency. The five-state phase frequency detector circuit frequency 1126 converges to the initial output frequency as indicated by time 1122. Meanwhile, the traditional three-state phase frequency detector circuit frequency 1128 does not converge on the initial output frequency until time 1124. The reduced time to lock to the initial output frequency by the five-state phase frequency detector circuit (e.g., phase frequency detector circuit 660 described in relation to FIG. 6, phase frequency detector circuit 1260 described in relation to FIG. 12, phase frequency detector circuit 1360 described in relation to FIG. 13, phase frequency detector circuit 1460 described in relation to FIG. 14) may result in an improvement to the overall system performance.

Referring now to FIG. 12, an example phase frequency detector circuit 1260 is provided.

As depicted in the example phase frequency detector circuit 1260, the primary reference signal (REF1) and the second reference signal (REF2) may be generated internally at the phase frequency detector circuit 1260 based on the reference signal (REF) received at the phase frequency detector circuit 1260 (e.g., reference signal 112 as depicted in FIG. 1).

As depicted in FIG. 12, the second reference signal (REF2) is generated by passing the reference signal (REF) through a buffer component 1262. The buffer component 1262 may transform the electrical impedance of the reference signal (REF) to provide a more ideal source signal. Additionally, the primary reference signal (REF1) may be generated by transmitting the second reference signal through a reference delay 1264. The reference delay 1264 defines the reference delay (Tdel) between the rising edge of the second reference signal (REF2) and the primary reference signal (REF1). As described in reference to FIG. 9, the delay between the rising edge of the second reference signal (REF2) and the primary reference signal (REF1) should ensure, among other things, that that the second up output signal (UP2) is at a logical high state before the next triggering edge of the primary reference signal (REF1) arrives.

As further depicted in the example phase frequency detector circuit 1260, the primary feedback signal (FB1) and the second feedback signal (FB2) may be generated internally at the phase frequency detector circuit 1260 based on the feedback signal (FB) received at the phase frequency detector circuit 1260 (e.g., reference signal 112 as depicted in FIG. 1).

As depicted in FIG. 12, the second feedback signal (FB2) is generated by passing the feedback signal (FB) through a buffer component 1266. The buffer component 1266 may transform the electrical impedance of the feedback signal (FB) to provide a more ideal source signal. Additionally, the primary feedback signal (FB1) may be generated by transmitting the second feedback signal through a feedback delay 1268. The feedback delay 1268 defines the reference delay (Tdel) between the rising edge of the second feedback signal (FB2) and the primary feedback signal (FB1). As described in reference to FIG. 9, the delay between the rising edge of the second feedback signal (FB2) and the primary feedback signal (FB1) should ensure, among other things, that that the second down output signal (DN2) is at a logical high state before the next triggering edge of the primary feedback signal (FB1) arrives.

Referring now to FIG. 13, another embodiment of a phase frequency detector circuit 1360 is provided. The phase frequency detector circuit 1360 of FIG. 13 further includes a reset pulse width delay 1370 configured to receive the logical NAND output 1372 of the up output signal 114 and the down output signal 115. The reset pulse width delay 1370 generates the third reset signal (RSTB) according to a delay defined by the reset pulse width delay 1370. The phase frequency detector circuit 1360 is otherwise equivalent to the phase frequency detector circuit 660 of FIG. 6.

The reset pulse width delay 1370 increases the pulse width of the third reset signal (RSTB), and subsequently the first reset signal (RST1) and the second reset signal (RST2). The reset pulse width of the first reset signal (RST1), the second reset signal (RST2), and the third reset signal (RSTB) may be increased to avoid a dead zone near the origin of the transfer function (e.g., where the frequency/phase difference between the reference signal and the feedback signal is minimal).

For example, in some embodiments in which the difference between the triggering edges of the feedback signal and reference signal is very small, one or more portions of the phase frequency detector circuit may not stabilize in the short time period. Thus, the output signal (e.g., up output signal 114, down output signal 115) may not be asserted. Such behavior creates a dead zone where the frequency/phase difference between the reference signal and the feedback signal is small. Utilizing the reset pulse width delay 1370 to increase the reset pulse width of the first reset signal (RST1), the second reset signal (RST2), and the third reset signal (RSTB) may reduce or eliminate the dead zone of the phase frequency detector circuit 1360.

However, as further depicted in FIG. 13, adding a reset pulse width delay 1370 may also require an adjustment to the secondary up output delay 1374 and the secondary down output delay 1376 to ensure the proper operation of the output signals (e.g., up output signal 114, down output signal 115) for example, the delay of the secondary up output delay 1374 and the secondary down output delay 1376 may be extended by a delay equivalent to the delay of the reset pulse width delay 1370.

Referring now to FIG. 14, an example embodiment of the phase frequency detector circuit 1460 is provided. As depicted in FIG. 14, the first flip-flop 666 is configured to generate an intermediate up output signal 1462 and the second flip-flop 668 is configured to generate an intermediate down output signal 1464.

The intermediate up output signal 1462 is transmitted to an up pulse width delay 1466, configured to delay the intermediate up output signal 1462 to generate a delayed intermediate up output signal 1467. Phase frequency detector circuit 1460 further comprises a logical OR gate 1470. The logical OR gate 1470 is configured to receive the intermediate up output signal 1462 and the delayed intermediate up output signal 1467 and generate the up output signal 114. By performing a logical OR operation on the intermediate up output signal 1462 and the delayed intermediate up output signal 1467, the pulse width of the up output signal 114 is effectively widened.

The intermediate down output signal 1464 is transmitted to a down pulse width delay 1468, configured to delay the intermediate down output signal 1464 to generate a delayed intermediate down output signal 1469. Phase frequency detector circuit 1460 further comprises a logical OR gate 1472. The logical OR gate 1472 is configured to receive the intermediate down output signal 1464 and the delayed intermediate down output signal 1469 and generate the down output signal 115. By performing a logical OR operation on the intermediate down output signal 1464 and the delayed intermediate down output signal 1469, the pulse width of the down output signal 115 is effectively widened.

Applying the pulse width reset delay to the intermediate output signals (e.g., intermediate up output signal 1462, intermediate down output signal 1464) may minimize the critical path delay in the phase frequency detector circuit 1460.

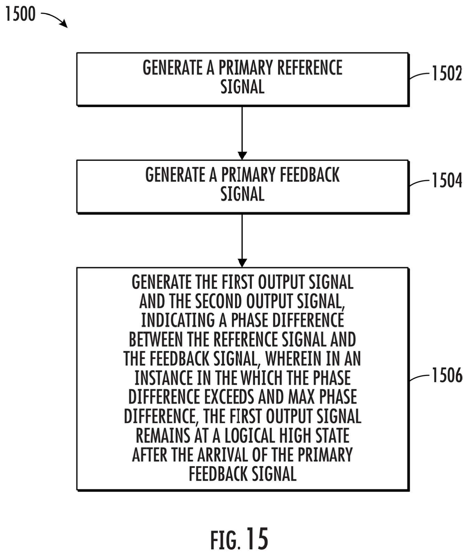

Referring now to FIG. 15, illustrating an example process 1500 for generating a first output signal (e.g., up output signal 114) and a second output signal (e.g., down output signal 115) at a phase frequency detector circuit (e.g., phase frequency detector circuit 660 described in relation to FIG. 6, phase frequency detector circuit 1260 described in relation to FIG. 12, phase frequency detector circuit 1360 described in relation to FIG. 13, phase frequency detector circuit 1460 described in relation to FIG. 14) is depicted.

At block 1502, the phase frequency detector circuit generates a primary reference signal (e.g., primary reference signal REF1), wherein the primary reference signal is generated by delaying the reference signal (e.g., reference signal REF) by a reference delay (e.g., reference delay 1264, Tdel). The phase frequency detector circuit may utilize any mechanism to delay the primary reference signal relative to the reference signal. In some embodiments, a second reference signal (e.g. second reference signal REF2) may be substantially equivalent in frequency and phase to the reference signal, for example, the second reference signal may be generated by transmitting the reference signal through a buffer (e.g., buffer component 1262). By delaying the second reference signal to generate the primary reference signal, the triggering edge of the second reference signal precedes the triggering edge of the primary reference signal by the reference delay.

At block 1504, the phase frequency detector circuit generates a primary feedback signal (e.g., primary feedback signal FB1), wherein the primary feedback signal is generated by delaying the feedback signal (e.g., feedback signal FB) by a feedback delay (e.g., feedback delay 1268, Tdel). The phase frequency detector circuit may utilize any mechanism to delay the primary feedback signal relative to the feedback signal. In some embodiments, a second feedback signal (e.g. second feedback signal FB2) may be substantially equivalent in frequency and phase to the feedback signal, for example, the second feedback signal may be generated by transmitting the feedback signal through a buffer (e.g., buffer component 1266). By delaying the second feedback signal to generate the primary reference signal, the triggering edge of the second feedback signal precedes the triggering edge of the primary feedback signal by the reference delay.

At block 1506, the phase frequency detector circuit generates the first output signal and the second output signal, indicating a phase difference between the reference signal and the feedback signal, wherein in an instance in which the phase difference exceeds a max phase difference indicated by a difference between the primary reference signal and the reference signal, the first output signal remains at an asserted state after the arrival of the primary feedback signal.

By causing the first output signal to remain at an asserted state after the arrival of the primary feedback signal in an instance in which the phase difference exceeds the max phase difference, the output of the phase frequency detector circuit is saturated. In an instance in which the frequency of the reference signal exceeds the frequency of the feedback signal, the first output may be associated with the up output signal.

The functionality of the phase frequency detector circuit is similar in an instance in which the frequency of the feedback signal exceeds the frequency of the reference signal in excess of a max phase difference. In such an example, the second output signal remains at an asserted state after the arrival of the primary reference signal.

As described herein, the max phase difference may be defined by the relative positions of the triggering edge of the primary reference signal and the second reference signal, or in an instance in which the feedback signal is operating at a higher frequency, the relative positions of the triggering edge of the primary feedback signal and the second feedback signal. Thus, a max phase difference may be at/or near a full phase cycle of the corresponding signal.

The phase frequency detector circuit configured to saturate one of the outputs (e.g., first output or second output) in an instance in which the phase or frequency difference exceeds a maximum phase/frequency difference may exhibit five stable states. For example, the phase frequency detector circuit may operate in accordance with a five-state state diagram (e.g., five-state state diagram 460 as described in relation to FIG. 4). Various circuit embodiments may be utilized to realize the functionality of the five-state state diagram, for example, phase frequency detector circuit 660 described in relation to FIG. 6, phase frequency detector circuit 1260 described in relation to FIG. 12, phase frequency detector circuit 1360 described in relation to FIG. 13, phase frequency detector circuit 1460 described in relation to FIG. 14.

By saturating the output of one of the outputs of the phase frequency detector circuit in an instance in which the phase or frequency difference between the reference signal and the feedback signal exceeds a maximum phase/frequency difference, phase frequency detector circuit may mitigate the adverse affects of cycle slipping and output flipping.

While this detailed description has set forth some embodiments of the present invention, the appended claims cover other embodiments of the present invention which differ from the described embodiments according to various modifications and improvements. For example, one skilled in the art may recognize that such principles may be applied to any electronic device that utilizes a phase locked loop to synchronize with a reference signal. For example, frequency synthesis applications, such as radio transmitters, receivers, and signal generators; clock generation applications, such as clock generation blocks in CPUs, GPUs, and networking equipment; communication system applications, such as synchronizing data signals in wired and wireless communications; motor control and robotics applications; telecommunications applications; and so on.

Within the appended claims, unless the specific term "means for" or "step for" is used within a given claim, it is not intended that the claim be interpreted under 35 U.S.C. 112, paragraph 6.

Use of broader terms such as "comprises," "includes," and "having" should be understood to provide support for narrower terms such as "consisting of," "consisting essentially of," and "comprised substantially of" Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A phase frequency detector circuit, comprising:
a plurality of reference signals, including a primary reference signal comprising a reference triggering edge;
a plurality of feedback signals, including a primary feedback signal comprising a feedback triggering edge; and
a first output signal and a second output signal, indicating a phase difference between the primary reference signal and the primary feedback signal;
wherein in an instance in which the phase difference exceeds a max phase difference indicated by a difference between the primary reference signal and the reference signal, the first output signal remains in an asserted state after an arrival of the primary feedback signal.

2. The phase frequency detector circuit of claim 1, wherein the first output signal is transitioned to an asserted state based on the reference triggering edge of the primary reference signal arriving before the feedback triggering edge of the primary feedback signal.

3. The phase frequency detector circuit of claim 2, the plurality of reference signals further comprising:
a second reference signal wherein the primary reference signal is generated by delaying the second reference signal by a reference delay, the second reference signal comprising a second reference triggering edge.

4. The phase frequency detector circuit of claim 3, wherein the max phase difference is defined based on a difference between the reference triggering edge and the second reference triggering edge.

5. The phase frequency detector circuit of claim 3 or 4, further comprising a secondary up output signal based on the first output signal and the second reference signal,
wherein the secondary up output signal is transitioned to an asserted state in an instance in which the first output signal is at an asserted state and the second reference triggering edge of the second reference signal is received.

6. The phase frequency detector circuit of claim 5, wherein in an instance in which the first output signal and the secondary up output signal are at an asserted state and the feedback triggering edge of the primary feedback signal is received, the secondary up output signal transitions to a de-asserted state and the first output signal remains in an asserted state.

7. The phase frequency detector circuit of claim 6, wherein in an instance in which the first output signal is in an asserted state, the secondary up output signal is in a de-asserted state, and the feedback triggering edge of the primary feedback signal is received, the first output signal transitions to a de-asserted state.

8. The phase frequency detector circuit of anyone of claims 2 to 7, the plurality of feedback signals further comprising:
a second feedback signal wherein the primary feedback signal is generated by delaying the second feedback signal by a feedback delay, the second feedback signal comprising a second feedback triggering edge.

9. The phase frequency detector circuit of claim 8, further comprising a secondary down output signal based on the second output signal and the second feedback signal,
wherein the secondary down output signal is transitioned to an asserted state in an instance in which the second output signal is in an asserted state and the second feedback triggering edge of the second feedback signal is received.

10. The phase frequency detector circuit of claim 9, wherein in an instance in which the second output signal and the secondary down output signal are in an asserted state and the reference triggering edge of the primary reference signal is received, the secondary down output signal transitions to a de-asserted state and the second output signal remains in an asserted state.

11. The phase frequency detector circuit of claim 10, wherein in an instance in which the second output signal is in an asserted state, the secondary down output signal is in a de-asserted state, and the reference triggering edge of the primary reference signal is received, the second output signal transitions to a de-asserted state.

12. The phase frequency detector circuit of any one of claims 1 to 11, comprising:
a first stage configured to generate:
the first output signal based on the primary reference signal, and
the second output signal based on the primary feedback signal; and
a second stage configured to generate:
a secondary up output signal based on the first output signal and a second reference signal, and
a secondary down output signal based on the second output signal and a second feedback signal.

13. The phase frequency detector circuit of claim 12, the first stage comprising:
a first flip-flop configured to receive the primary reference signal, a first reset signal, and a source voltage, and generate the first output signal; and
a second flip-flop configured to receive the primary feedback signal, a second reset signal, and the source voltage, and generate the second output signal.

14. The phase frequency detector circuit of claim 13, wherein the first flip-flop and the second flip-flop are active high flip-flops.

15. The phase frequency detector circuit of claim 13 or 14, wherein the first reset signal and the second reset signal are based on the secondary up output signal and the secondary down output signal, respectively.

16. The phase frequency detector circuit of any one of claims 12 to 15, the second stage comprising:
a third flip-flop configured to receive the second reference signal, a third reset signal, and the first output signal, and generate the secondary up output signal; and
a fourth flip-flop configured to receive a secondary feedback signal, the third reset signal, and the second output signal, and generate the secondary down output signal.

17. The phase frequency detector circuit of claim 16, wherein the third flip-flop and the fourth flip-flop are active low flip-flops.

18. The phase frequency detector circuit of claim 16 or 17, further comprising:
a logical NAND gate configured to receive the first output signal and the second output signal and generate the third reset signal based on a logical NAND operation of the first output signal and the second output signal.

19. A method for generating a first output signal and a second output signal at a phase frequency detector circuit based on a reference signal and a feedback signal, the method comprising:
generating a primary reference signal, wherein the primary reference signal is generated by delaying the reference signal by a reference delay;
generating a primary feedback signal, wherein the primary feedback signal is generated by delaying the feedback signal by a feedback delay; and
generating the first output signal and the second output signal, indicating a phase difference between the reference signal and the feedback signal,
wherein in an instance in which the phase difference exceeds a max phase difference indicated by a difference between the primary reference signal and the reference signal, the first output signal remains at an asserted state after an arrival of the primary feedback signal.

20. A phase-locked loop configured to generate an output signal based on a reference clock, comprising:
a voltage-controlled oscillator configured to generate the output signal based on an oscillating voltage signal;
a low-pass filter electrically connected to the voltage-controlled oscillator and configured to generate the oscillating voltage signal based on a charge pump output signal;
a charge pump circuit electrically connected to the low-pass filter and configured to generate the charge pump output signal based on a first output signal and a second output signal; and
a phase frequency detector circuit, comprising:
a plurality of reference signals based on the reference clock, including a primary reference signal comprising a reference triggering edge;
a plurality of feedback signals based on the oscillating voltage signal, including a primary feedback signal comprising a feedback triggering edge; and
the first output signal and the second output signal, indicating a phase difference between the primary reference signal and the primary feedback signal;
wherein in an instance in which the phase difference exceeds a max phase difference indicated by a difference between the primary reference signal and the reference signal, the first output signal remains at an asserted state after an arrival of the primary feedback signal.
